(19) Europäisches Patentamt
European Patent Office
Office européen des brevets

(11) **EP 1 049 908 B1**

(12) **EUROPÄISCHE PATENTSCHRIFT**

(45) Veröffentlichungstag und Bekanntmachung des Hinweises auf die Patenterteilung:
**27.08.2003 Patentblatt 2003/35**

(21) Anmeldenummer: **99936400.3**

(22) Anmeldetag: **02.06.1999**

(51) Int Cl.⁷: **G01B 7/30**, G01D 5/16

(86) Internationale Anmeldenummer:
**PCT/DE99/01632**

(87) Internationale Veröffentlichungsnummer:
**WO 00/012957 (09.03.2000 Gazette 2000/10)**

(54) **ANORDNUNG ZUR DREHWINKELERFASSUNG EINES DREHBAREN ELEMENTS**

SYSTEM FOR DETECTING THE ANGLE OF ROTATION OF A ROTATABLE ELEMENT

CONFIGURATION DESTINEE A LA DETECTION DE L'ANGLE DE ROTATION D'UN ELEMENT ROTATIF

(84) Benannte Vertragsstaaten:
**DE FR GB IT SE**

(30) Priorität: **29.08.1998 DE 19839446**

(43) Veröffentlichungstag der Anmeldung:
**08.11.2000 Patentblatt 2000/45**

(73) Patentinhaber: **ROBERT BOSCH GMBH**
**70442 Stuttgart (DE)**

(72) Erfinder:
- **MARX, Klaus**
  **D-70565 Stuttgart (DE)**
- **KITTEL, Hartmut**
  **D-71287 Weissach-Flacht (DE)**
- **JOST, Franz**
  **D-70565 Stuttgart (DE)**

(56) Entgegenhaltungen:
EP-A1- 0 685 707          DE-A1- 19 642 752
US-A- 5 435 070          US-A- 5 796 249

EP 1 049 908 B1

**Beschreibung**

Die vorliegende Erfindung betrifft eine Anordnung zur Drehwinkelerfassung eines drehbaren Elements nach dem Oberbegriff des Patentanspruchs 1 sowie ein entsprechendes Verfahren nach dem Oberbegriff des Patentanspruchs 9.

Anordnungen dieser Art, mit denen eine berührungslose Drehwinkelerfassung durchführbar ist, sind beispielsweise aus der DE-OS 195 43 562 bekannt. Bei diesen Anordnungen ist mit der drehbaren Welle, deren Winkelstellung ermittelt werden soll, ein Magnet verbunden. Das Magnetfeld, das sich mit dem Drehwinkel der Welle ändert, wird mit Hilfe zweier Sensorelemente gemessen. Diese Sensorelemente sind entweder zwei Hallsensorelemente, die gegeneinander um einen Winkel von 90° verdreht sind, oder zwei magnetoresistive Sensorelemente, die gegeneinander um 45° verdreht sind. Die Sensorelemente werden mit gegeneinander in geeigneter Weise phasenverschobenen Wechselspannungssignalen versorgt. Die Überlagerung der Ausgangssignale der Sensorelemente ergibt einen Signalverlauf, der repräsentativ ist für die Winkelstellung. Die in dieser Druckschrift beschriebenen Anordnungen zur berührungslosen Drehwinkelerfassung weisen jeweils zwei gleichartige Sensorelemente auf. Dies kann zu Nachteilen führen, da Hall-Sensoren beispielsweise eine große Temperaturabhängigkeit und eine große Streßabhängigkeit aufweisen. Magnetoresistive Sensorelemente weisen dagegen bezüglich der Temperatur- und Streßabhängigkeit günstigere Eigenschaften auf, sie sind weniger temperatur- und streßabhängig als Hall-Sensoren, haben jedoch den Nachteil, daß aufgrund des physikalischen Effekts nur ein Winkelbereich von 180° eindeutig erfaßt werden kann. Ein solcher Winkelbereich ist beispielsweise bei der Erfassung der Stellung der Nockenwelle einer Brennkraftmaschine bzw. bei Lenkradwinkel-Meßverfahren zu klein.

Aus der DE-P 197 22 016 ist eine Anordnung zur berührungslosen Drehwinkelerfassung eines drehbaren Elements bekannt, bei der unter Auswertung von magnetisch beeinflußbaren Eigenschaften einer Sensoranordnung mit wenigstens zwei Sensorelementen eine vom drehbaren Element erzeugte oder beeinflußte magnetische Feldstärke in einer Auswerteschaltung detektiert und zur Ermittlung der Drehlage herangezogen wird, wobei ein Sensorelement unter Ausnutzung des magnetoresistiven Effekts, und das andere Sensorelement unter Ausnutzung des Halleffekts arbeitet, und die von den beiden Sensorelementen abgegebenen Signale miteinander kombiniert werden. Die Kombination von magnetoresistiven Sensoren und Hall-Sensoren erweist sich in der Praxis als sehr aufwendig.

Aufgabe der vorliegenden Erfindung ist die Schaffung einer Anordnung bzw. eines Verfahrens zur Drehwinkelerfassung, mit welcher bzw. welchem ein möglichst großer Winkelbereich, insbesondere 0°-360°, mit geringem Aufwand eindeutig erfaßbar ist.

Diese Aufgabe wird gelöst durch eine Anordnung mit den Merkmalen des Patentanspruchs 1 sowie ein Verfahren mit den Merkmalen des Patentanspruchs 9.

Erfindungsgemäß ist es nun erstmals möglich, eine magnetoresistive Sensoranordnung zur eindeutigen Bestimmung eines Winkels zwischen 0° und 360° zu verwenden. Hierbei werden, im Gegensatz zu Sensoranordnungen gemäß dem Stand der Technik, keine zusätzlichen Hall-Sensoren benötigt. Hierdurch ist der Kostenaufwand zur Bereitstellung einer Anordnung zur Drehwinkelerfassung vermindert. Vorteilhafte Anwendungen ergeben sich beispielsweise bei der Erfassung der Stellung einer Nockenwelle einer Brennkraftmaschine. Die vorliegende Erfindung ist ferner in vorteilhafter Weise bei Lenkradwinkel-Meßverfahren einsetzbar, da die gegenüber herkömmlichen Verfahren geschaffene Vergrößerung des Eindeutigkeitsbereiches auf 360° zu einer Erhöhung der Toleranzgrenzen des Gesamtsystems führt.

Vorteilhafte Ausgestaltungen der Erfindung sind Gegenstand der Unteransprüche.

Gemäß einer bevorzugten Ausgestaltung weist die Sensoranordnung eine Anzahl von magnetorestistiven Elementen auf, welche zu wenigstens zwei Brückenschaltungen, insbesondere Wheatstone-Brücken, verschaltet sind, von denen die eine ein dem Cosinus des Winkels des zu detektierenden ersten Magnetfeldes $B_{ext}$ bezüglich einer Referenzrichtung zugeordnetes, und eine weitere ein dem Sinus dieses Winkels zugeordnetes Signal liefert. Auf der Grundlage dieser linear unabhängigen Signale ist eine einfache Signalauswertung durchführbar.

Zweckmäßigerweise sind die magnetoresistiven Elemente als AMR-Meßstreifen ausgebildet. Derartige Meßstreifen sind in relativ einfacher und preiswerter Weise in geeigneter Orientierung auf ein Substrat aufbringbar.

Es ist bevorzugt, daß die Stromflußrichtungen in jeweils zwei einem Brückenzweig der Brückenschaltungen zugeordneten magnetoresistiven Elementen senkrecht zueinander verlaufen.

Zweckmäßigerweise sind die Brückenschaltungen, insbesondere um einen Winkel von 45°, verdreht zueinander angeordnet. Mit dieser Anordnung sind Sinus- und Cosinussignale in einfacher Weise extrahierbar.

Es ist bevorzugt, daß das magnetische Hilfsfeld $B_H$ in den Brückenschaltungen unterschiedliche Richtungen aufweist, wobei diese Richtungen insbesondere einen Winkel von 45° einschließen.

Zweckmäßigerweise sind die magnetoresistiven Elemente mäandriert ausgebildet. Durch diese Maßnahme lassen sich höhere Sensorsignale erzielen, die einfacher auswertbar sind.

Es wird bevorzugt, das magnetische Hilfsfeld $B_H$ mittels einer Planarspule zu erzeugen, die durch eine nichtleitende Zwischenschicht elektrisch isoliert bezüglich den magnetoresistiven Elementen angeordnet ist. Mit einer derartigen Spule ist der Verdrahtungsaufwand relativ gering, ferner sind Betrag und Richtung des Hilfsfeldes $B_H$ in gewünschter Weise einstellbar.

Gemäß einer bevorzugten Ausführungsform des erfindungsgemäßen Verfahrens wird die Korrelierung mittels einer Bereichsfunktion F der Form

$$F = ((0° \leq \alpha_{AMR180} \leq f(\alpha_1, \alpha_2)) \text{UND}((\delta U_{cos} > S) \text{ODER}((\delta U_{sin} < -S) \text{UND}(|\delta U_{cos}| < S)))) \text{ ODER}$$

$$((f(\alpha_1, \alpha_2) < \alpha_{AMR180} \leq 180°) \text{UND}((\delta U_{cos} > S) \text{ODER}((\delta U_{sin} > S) \text{UND}(|\delta U_{cos}| < S))))$$

durchgeführt, wobei $\alpha_{AMR180}$ ein ohne Anliegen des Hilfsfeldes $B_H$ mit 180°-Eindeutigkeitsbereich erfaßter Drehwinkel, S eine einstellbare Signifikanzschwelle, $\delta U_{cos}$ bzw. $\delta U_{sin}$ die winkelabhängigen Änderungssignale der Sensoranordnung, und $f(\alpha_1, \alpha_2)$ eine Additions- bzw. Subtraktionsfunktion der Winkelausrichtungen der Brückenschaltungen bzw. des Hilfsfeldes am Ort der jeweiligen Brückenschaltungen bezüglich einer Referenzrichtung ist. Hiermit ist ein rechnerisch in unaufwendiger Weise durchzuführendes Verfahren zur eindeutigen Drehwinkelbestimmung über einen Winkelbereich von 360° zur Verfügung gestellt. Die Form der Bereichsfunktion hängt von der Richtung des magnetischen Hilfsfeldes $B_H$ in den jeweiligen Brückenschaltungen ab. Eine Unterscheidung der Winkelbereiche $0 \leq \alpha \leq 180°$ und $180° \leq \alpha \leq 360°$ durch Verwendung eines magnetischen Hilfsfeldes $B_H$ ist bei beliebigen Richtungen des Hilfsfeldes $B_H$ möglich, wobei darauf zu achten ist, daß die Richtung von $B_H$ am Ort der Brückenschaltung 1 sich von derjenigen am Ort der Brückenschaltung 11 unterscheidet. Vorteilhaft ist insbesondere, wenn die $B_H$-Richtungen sich um 45° unterscheiden.

Gemäß einer besonders bevorzugten Ausführungsform des erfindungsgemäßen Verfahrens ist die Funktion $f(\alpha_1, \alpha_2)$ eine Funktion der Form $\alpha_1 + \alpha_2$. Für den Fall, daß das Hilfsfeld $B_H$ am Ort der Brückenschaltung 1 in Richtung $\alpha = 90°$, und am Ort der Brückenschaltung 11 in Richtung $\alpha = 45°$ angelegt wird, ergibt sich beispielsweise die Bereichsfunktion

$$F = ((0° \leq \alpha_{AMR180} \leq 135°) \text{UND}((\delta U_{cos} > S) \text{ODER}((\delta U_{sin} < -S) \text{UND}(|\delta U_{cos}| < S)))) \text{ ODER}$$

$$((135° < \alpha_{AMR180} \leq 180°) \text{UND}((\delta U_{cos} > S) \text{ODER}((\delta U_{sin} > S) \text{UND}(|\delta U_{cos}| < S)))).$$

Gemäß einer weiteren besonders bevorzugten Ausführungsform des erfindungsgemäßen Verfahrens ist die Funktion $f(\alpha_1, \alpha_2)$ eine Funktion der Form $|\alpha_1 - \alpha_2|$. Für den Fall, daß das magnetische Hilfsfeld $B_H$ am Ort der Brückenschaltung 1 eine Richtung von $\alpha = 90°$, und bei der Brückenschaltung 11 eine Richtung von $\alpha = 135°$ aufweist, ergibt sich beispielsweise eine Bereichsfunktion

$$F = ((0° \leq \alpha_{AMR180} \leq 45°) \text{UND}((\delta U_{cos} > S) \text{ODER}((|\delta U_{cos}| < S) \text{UND}(\delta U_{sin} < -S)))) \text{ ODER}$$

$$((45° < \alpha_{AMR180} \leq 180°) \text{UND}((\delta U_{cos} > S) \text{ODER}((|\delta U_{cos}| < S) \text{UND}(\delta U_{sin} > S)))).$$

Die Erfindung wird nun anhand einer bevorzugten Ausführungsform unter Bezugnahme auf die beigefügte Zeichnung im einzelnen erläutert. In dieser zeigt

Fig. 1 eine schematische Darstellung einer bevorzugten Ausführungsform einer Anordnung zur Drehwinkelerfassung eines drehbaren Elements,

Fig. 2 Änderungen von bei der erfindungsgemäßen Anordnung zur Drehwinkelerfassung auftretenden Cosinus- und Sinus-Brückensignalspannungen bei Anlegen eines magnetischen Hilfsfeldes in Abhängigkeit von der Richtung des externen, zu detektierenden Magnetfeldes, und

Fig. 3 eine Draufsicht auf ein mögliches Layout einer bevorzugten Ausführungsform einer erfindungsgemäßen Anordnung zur Drehwinkelerfassung.

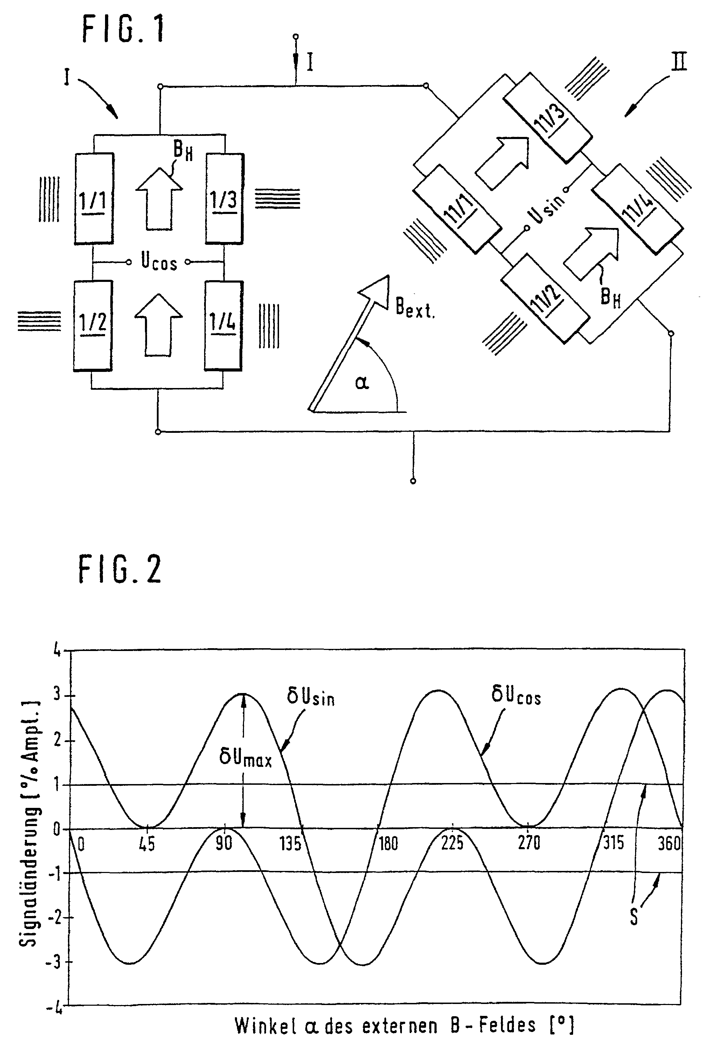

Die in Fig. 1 dargestellte Sensoranordnung einer erfindungsgemäßen Anordnung zur Drehwinkelerfassung weist zwei Wheatstone-Brücken 1, 11 auf. Als magnetoresistive Elemente weisen die jeweiligen Wheatstone-Brücken 1, 11 anisotrope Magnetowiderstands-Dünnschichtsensoren bzw. AMR-Meßstreifen 1/1 bis 1/4 bzw. 11/1 bis 11/4 auf.

Der elektrische Widerstand von AMR-Materialien, wie z.B. Permalloy, hängt ab von dem Winkel zwischen der Magnetisierungsrichtung bzw. der Richtung eines angelegten magnetischen Feldes $B_{ext}$ und der Richtung eines durch die AMR-Materialien fließenden elektrischen Stromes I ab. Die Stromrichtung innerhalb der AMR-Meßstreifen ist in Fig. 1 schematisch durch die den jeweiligen AMR-Meßstreifen zugeordneten Linienscharen dargestellt (es ist zu erkennen, daß die jeweiligen Brückenzweige der Wheatstone-Brücken je zwei AMR-Meßstreifen mit senkrecht zueinander verlaufenden Stromrichtungen aufweisen). Während die Stromrichtung durch die Geometrie der AMR-Meßstreifen festgelegt ist, folgt die Richtung der Magnetisierung derjenigen des zu detektierenden äußeren Magnetfeldes. In der Darstellung der Fig. 1 ist die einem Drehwinkel $\alpha$ entsprechende Richtung des externen Magnetfeldes $B_{ext}$ mittels eines länglichen Pfeiles dargestellt. Die Winkelabhängigkeit des elektrischen Widerstandes der AMR-Meßstreifen besitzt eine 180°-Periodizität, wobei der Widerstand maximal ist, wenn die Richtung der Magnetisierung parallel bzw. antiparallel zur Stromrichtung liegt, und minimal, wenn sie senkrecht zur Stromrichtung steht. Die jeweils zu einer Wheatstone-Brücke 1, 11 verschalteten AMR-Meßstreifen 1/1 bis 1/4 und 11/1 bis 11/4 dienen zur Extraktion des winkelabhängigen Nutzsignals. Das aus der Wheatstone-Brücke 1 erhaltene Signal $U_{cos}$ besitzt eine 180°-Periodizität und zeigt einen cosinusförmigen Verlauf $U_{cos} \sim \cos(2\alpha)$. Der Winkel $\alpha$ gibt, wie gesagt, die Richtung des zu detektierenden äußeren Magnetfeldes an. Die zweite Wheatstone-Brücke 11 ist bezüglich der ersten Wheatstone-Brücke 1 um 45° verdreht. Die AMR-Meßstreifen sind entsprechend angeordnet, so daß die Wheatstone-Brücke 11 ein sinus-förmiges Ausgangssignal $U_{sin} \sim \sin(2\alpha)$ liefert. Durch Arcustangens-Bildung in einer (nicht dargestellten) elektronischen Auswerteschaltung erhält man den zu messenden Winkel $\alpha$. Aufgrund der $2\alpha$-Abhängigkeit der Brückenspan-nungen liegt eine 180°-Periodizität vor, so daß eine absolute Winkelangabe nur im Bereich $0° \leq \alpha \leq 180°$ möglich ist.

Zur Unterscheidung der beiden Winkelbereiche $0° \leq \alpha \leq 180°$ und $180° \leq \alpha \leq 360°$ wird kurzfristig ein Hilfsmagnetfeld $B_H$ angelegt, wie dies in Fig. 1 durch die breiteren Pfeile angedeutet ist. Durch dieses Magnetfeld $B_H$ ändert sich geringfügig die Richtung der Magnetisierung in dem AMR-Meßstreifen 1/1 bis 1/4 bzw. 11/1 bis 11/4, so daß auch die von den Wheatstone-Brücken 1, 11 abgeleiteten Signale $U_{cos}$ bzw. $U_{sin}$ eine entsprechende Änderung erfahren. Diese Signal- bzw. Spannungsänderungen $\delta U_{cos}$ und $\delta U_{sin}$ relativ zu der Messung ohne angelegtes Hilfsfeld $B_H$ werden in einer logischen Verknüpfung, der sogenannten Bereichsfunktion ausgewertet. Die Bereichsfunktion, welche weiter unten im einzelnen erläutert ist, kann die logischen Werte "0" oder "1" annehmen, wodurch entschieden werden kann, ob der gemessene Winkel $\alpha$ im Bereich von 0° bis 180° oder von 180° bis 360° liegt. Damit ist mittels einer AMR-Winkelsensoranordnung eine absolute Winkelmessung über den Gesamtbereich 0° bis 360° erzielbar.

Die Richtung des an der Wheatstone-Brücke 11 anliegenden magnetischen Hilfsfeldes (Winkel $\alpha_2$) weist gegenüber dem an der Wheatstone-Brücke 1 anliegenden Hilfsfeld $B_H$ (Winkel $\alpha_1$) eine um 45° unterschiedliche Richtung auf. Dies zeigt beispielhaft Fig. 1, in der das Hilfsfeld $B_H$ an der Wheatstone-Brücke 11 in Richtung $\alpha_2 = 45°$ und an der Wheatstone-Brücke 1 in Richtung $\alpha_1 = 90°$ orientiert ist. Für diese Ausrichtung des Hilfsfeldes $B_H$ sind in Fig. 2 die zugehörigen Signaländerungen $\delta U_{cos}$ und $\delta U_{sin}$ dargestellt. Zur sicheren Auswertung der Spannungsänderungen wird eine Signifikanzschwelle S definiert. Die Signifikanzschwelle S kann innerhalb einer großen Bandbreite von bei-spielsweise $0,05 * \delta U_{max} \leq S \leq 0,35 * \delta U_{max}$ gewählt werden. In Fig. 2 ist eine Signifikanzschwelle $S = 0,33 * \delta U_{max}$ gewählt. Bezeichnet nun $\alpha_{AMR180}$ den Winkel, der ohne Hilfsfeld gemessen wird und, aufgrund der 180°-Periodizität, auf den Eindeutigkeitsbereich 0°-180° beschränkt ist, so lautet die logische Bereichsfunktion F:

$$F = ((0°\leq\alpha_{AMR180}\leq135°)\text{UND}((\delta U_{cos}>S)\text{ODER}((\delta U_{sin}<-S)\text{UND}(|\delta U_{cos}|<S)))) \text{ ODER}$$

$$((135°<\alpha_{AMR180}\leq180°)\text{UND}((\delta U_{cos}>S) \text{ ODER } ((\delta U_{sin}>S) \text{ UND } (|\delta U_{cos}|<S))))$$

wobei

F =   FALSCH bzw. "0" bedeutet, daß der Winkel $\alpha$ der zu detektierenden Feldrichtung des externen Magnetfeldes $B_{ext}$ im Bereich 0° bis 180° liegt, d.h. $\alpha=\alpha_{AMR180}$, und

F =   WAHR bzw. "1" bedeutet, daß der Winkel $\alpha$ der zu detektierenden Feldrichtung des Magnetfeldes $B_{ext}$ im Bereich 180° bis 360° liegt, d.h. $\alpha=\alpha_{AMR180}+180°$.

In der nachfolgenden Tabelle 1 ist die logische Verknüpfung der Bereichsfunktion im einzelnen dargestellt. Zu erkennen ist, daß die Signaländerung $\delta U_{sin}$ nur dann für die Bereichsentscheidung herangezogen wird, wenn der Betrag der Signaländerung $\delta U_{cos}$ unterhalb der Signifikanzschwelle S liegt. Dieser Fall tritt gemäß Fig. 2 insbesondere für Winkelbereiche um $\alpha=0°$, 90°, 180°, 270° und 360° bzw. für $\alpha_{AMR180} = 0°$, 90° und 180° auf.

| $\delta U_{cos}$ | $\delta U_{sin}$ | $\alpha_{AMR180}$ | F |
|---|---|---|---|
| - | +;?;- | u;o | 0 |
| + | +;?;- | u;o | 1 |

(fortgesetzt)

| $\delta U_{cos}$ | $\delta U_{sin}$ | $\alpha_{AMR180}$ | F |
|---|---|---|---|
| ? | + | u | 0 |
| ? | - | u | 1 |
| ? | - | o | 0 |
| ? | + | o | 1 |

Die logische Bereichsfunktion F nimmt hierbei folgende Werte an:

0 für $0°\leq\alpha<180°$, und
1 für $180°\leq\alpha<360°$.

Für $\alpha_{AMR180}$ sind die logischen Zustände:

u für $0°\leq\alpha_{AMR180}\leq135°$, und
o für $135°<\alpha_{AMR180}\leq180°$

maßgeblich.
Die logischen Zustände der Funktionen $\delta U_{cos}$ und $\delta U_{sin}$ sind wie folgt definiert:

+ für $\delta U>+S$,
? für $|\delta U|<+S$, und
- für $\delta U<-S$.

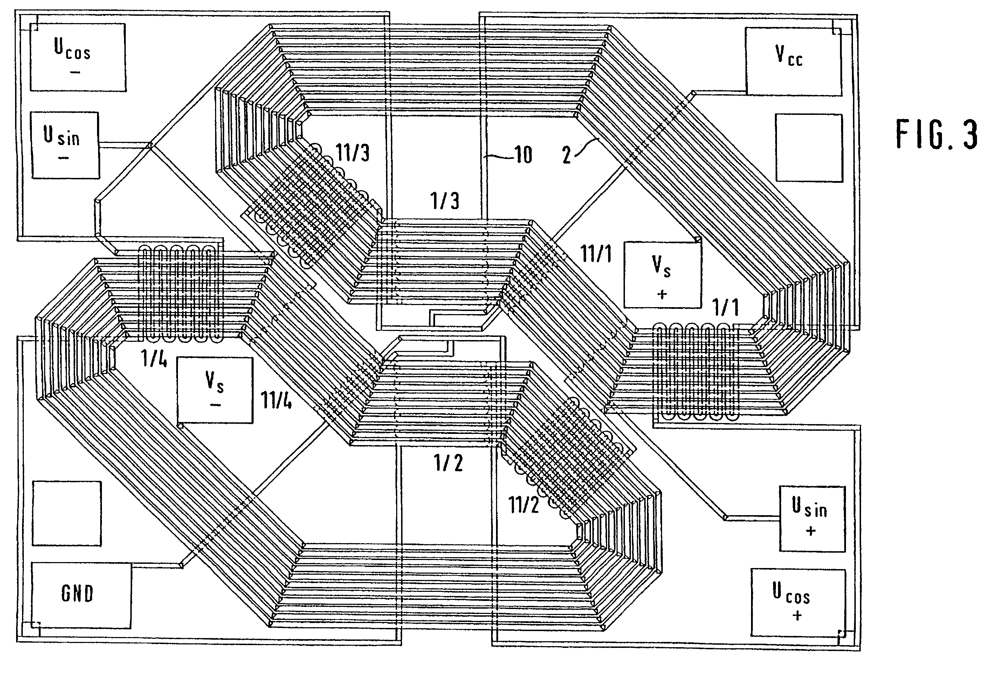

In Fig. 3 ist ein bevorzugtes Layout eines erfindungsgemäßen 360°-AMR-Winkelsensors dargestellt, welcher mittels Dünnschichttechnologie herstellbar ist. Die einzelnen AMR-Meßstreifen bzw. Widerstände sind auch hier mit Bezugszeichen 1/1 bis 1/4 (COS-Brücke) und 11/1 bis 11/4 (SIN-Brücke) bezeichnet. Die Dicke dieser Widerstände liegt typischerweise im Bereich von 20 nm bis 50 nm. Die Streifenbreite beträgt beispielsweise 10 μm. Die Verschaltung bzw. Metallisierung der AMR-Widerstände 1/1 bis 1/4 und 11/1 bis 11/4 zu zwei Wheatstone-Brücken ist z.B. durch Aluminium oder Kupferstreifen 10 in Dünnschichttechnologie realisiert.

Das Hilfsfeld $B_H$ wird durch eine Dünnschicht-Planarspule 2 erzeugt, die durch eine nichtleitende Zwischenschicht von typischerweise 200 nm bis 500 nm Dicke elektrisch isoliert über den AMR-Widerständen 1/1 bis 1/4 und 11/1 bis 11/4 bzw. deren Metallisierung liegt. Die Form der Planarspule 2 ist so gewählt, daß das Hilfsfeld $B_H$ entsprechend der Fig. 1 im Bereich der Wheatstone-Brücke 1 (COS-Brücke) in Richtung $\alpha=90°$, und im Bereich der Wheatstone-Brücke 11 (SIN-Brücke) in Richtung $\alpha=45°$ orientiert ist und im Bereich der AMR-Meßstreifen parallel zur Schichtebene verläuft. Insbesondere verlaufen die Spulenwindungen der Planarspule 2 parallel bzw. senkrecht zur Streifen- bzw. Mäanderrichtung der AMR-Widerstände. Die Breite der Spulenwindungen der Planarspule 2 orientiert sich typischerweise an der Breite der AMR-Widerstände. Im gezeigten Beispiel beträgt sie 12 μm. Die Schichtdicke der Spulenwindungen der Planarspule 2 liegt typischerweise im Bereich 500 nm bis 1.000 nm. Im dargestellten Beispiel sind die Wheatstone-Brücken 1, 11 parallel geschaltet. Das gesamte Sensorelement weist einschließlich der beiden Spulenanschlüsse acht Anschlußpads, nämlich $U_{cos}$-, $U_{cos}$+, $U_{sin}$-, $U_{sin}$+, $V_{cc}$, $V_s$-, $V_s$+ und GND, auf. Eine Verpackung in einem geeigneten Gehäuse, insbesondere einem SOIC8-Gehäuse, ist in einfacher Weise möglich.

Die Erzeugung des magnetischen Hilfsfeldes $B_H$ durch eine Planarspule 2 ist nicht auf die Anordnung und die mäandrierte Form der AMR-Widerstände gemäß Fig. 3 beschränkt. Die Ausführung bzw. Anordnung der AMR-Widerstände muß lediglich gewährleisten, daß die Stromrichtung in den Widerständen der Wheatstone-Brücken 1, 11 in den in Fig. 1 eingezeichneten Richtungen verläuft. So ist die Hilfsfelderzeugung durch eine Planarspule 2 auch bei alternativen Anordnungen der AMR-Widerstände, wie beispielsweise der in der EP 0 671 605 A2 beschriebenen sternförmigen Ineinanderschachtelung möglich. Ebenso ist beispielsweise anstelle der mäandrierten AMR-Widerstände bzw. Widerstandsstreifen auch eine Reihenschaltung von beliebigen rechteckigen, quadratischen, kreisförmigen oder elliptischen AMR-Dünnschichtstrukturen, wie sie beispielsweise in der WO 97 00 426 A1 und der DE 43 27 458 C2 beschrieben sind, möglich.

Der (nicht im einzelnen dargestellten) Auswerteschaltung werden die zur Realisierung der Bereichsfunktion notwendigen Größen zugeführt. Die Ermittlung des Winkels $\alpha_{AMR180}$ ohne angelegtes Hilfsfeld $B_H$, d.h. bei stromloser Planarspule 2, erfolgt beispielsweise über eine Mikroprozessor-Schaltung nach bekanntem Verfahren durch Berechnung des Arcustangens gemäß der Formel $\alpha=0,5*\arctan(U_{sin}/U_{cos})$ oder über ein anderes geeignetes Berechnungsverfahren. Mittels weiterer digitaler Schaltkreise werden die Signalspannungen $U_{cos}$, $U_{sin}$ und der Winkel $\alpha_{AMR180}$

gespeichert. Anschließend wird eine erneute Messung mit angelegtem Hilfsfeld $B_H$, d.h. stromführender Planarspule 2, durchgeführt. Über weitere logische Schaltkreise erfolgt die Realisierung der oben angegebenen Bereichsfunktion F, die unter Einbeziehung der Signifikanzschwelle S die Vorzeichen der Spannungsänderungen $\delta U_{cos}$ und $\delta U_{sin}$ auswertet und entscheidet, ob der auszugebende Meßwinkel gleich $\alpha_{AMR180}$ oder $\alpha_{AMR180}+180°$ ist.

**Patentansprüche**

1. Anordnung zur Drehwinkelerfassung eines drehbaren Elements, bei der unter Auswertung von magnetisch beeinflußbaren Eigenschaften einer Sensoranordnung ein von einem drehbaren Element erzeugtes oder beeinflußtes erstes Magnetfeld $B_{ext}$ in einer Auswerteschaltung detektierbar und zur Ermittlung des Drehwinkels heranziehbar ist, wobei die Sensoranordnung unter Ausnutzung des magnetoresistiven Effekts über einen ersten Winkelbereich, insbesondere einen Winkelbereich von 180°, einer Richtung des Magnetfeldes $B_{ext}$ eindeutig zuordnenbare Signale liefert, **gekennzeichnet durch** Mittel (2) zum wahlweisen Anlegen eines magnetischen Hilfsfeldes $B_H$ an die Sensoranordnung, mittels derer eine Modifikation der der Richtung des ersten Magnetfeldes $B_{ext}$ zuordnenbaren Signale zur eindeutigen Zuordnung eines Winkels über einen zweiten Winkelbereich, insbesondere 360°, erzielbar ist.

2. Anordnung nach Anspruch 1, **dadurch gekennzeichnet, daß** die Sensoranordnung eine Anzahl von magnetoresistiven Elementen (1/1-1/4; 11/1-11/4) aufweist, welche zu wenigstens zwei Brückenschaltungen, insbesondere Wheatstone-Brücken (1,11), verschaltet sind, von denen die eine ein dem Cosinus des Winkels des ersten Magnetfeldes $B_{ext}$ bezüglich einer Referenzrichtung zugeordnetes, und eine weitere ein dem Sinus dieses Winkels zugeordnetes Signal liefert.

3. Anordnung nach Anspruch 2, **dadurch gekennzeichnet, daß** die magnetoresistiven Elemente AMR-Meßstreifen (1/1-1/4; 11/1-11/4) sind.

4. Anordnung nach einem der vorstehenden Ansprüche, **dadurch gekennzeichnet, daß** die Stromflußrichtungen in jeweils zwei einem Brückenzweig der Brückenschaltungen (1,11) zugeordneten magnetoresistiven Elementen senkrecht zueinander verlaufen.

5. Anordnung nach einem der vorstehenden Ansprüche, **dadurch gekennzeichnet, daß** die Brückenschaltungen (1,11), insbesondere um einen Winkel von 45°, verdreht zueinander angeordnet sind.

6. Anordnung nach einem der vorstehenden Ansprüche, **dadurch gekennzeichnet, daß** das magnetische Hilfsfeld $B_H$ in den Brückenschaltungen (1,11) unterschiedliche Richtungen aufweist, wobei diese Richtungen insbesondere einen Winkel von 45° einschließen.

7. Anordnung nach einem der vorstehenden Ansprüche, **dadurch gekennzeichnet, daß** die magnetoresistiven Elemente (1/1-1/4; 11/1-11/4) mäandriert ausgebildet sind.

8. Anordnung nach einem der vorstehenden Ansprüche, **dadurch gekennzeichnet, daß** das magnetische Hilfsfeld $B_H$ mittels einer Planarspule (2) erzeugbar ist, die durch eine nichtleitende Zwischenschicht elektrisch isoliert bezüglich den magnetoresistiven Elementen (1/1-1/4; 11/1-11/4) und deren Metallisierung angeordnet ist.

9. Verfahren zur Drehwinkelerfassung eines drehbaren Elements, bei dem unter Auswertung von magnetischen Eigenschaften einer Sensoranordnung ein von dem drehbaren Element verursachtes oder beeinflußtes erstes magnetisches Feld $B_{ext}$ in einer Auswerteschaltung detektiert und zur Ermittlung des Drehwinkels herangezogen wird, **gekennzeichnet durch** folgende Schritte:

    a) Bestimmung der von der Sensoranordnung erfaßten Signale bei Anliegen des ersten Feldes $B_{ext}$,
    b) zeitweises Anlegen eines zusätzlichen magnetischen Hilfsfeldes $B_H$ an die Sensoranordnung,
    c) Bestimmung der Änderung der von der Sensoranordnung erfaßten Signale bezüglich der bei Nicht-Anliegen des Hilfsfeldes $B_H$ erfaßten Signale zum Erhalt von drehwinkelabhängigen Änderungssignalen, und
    d) Korrelierung der Änderungssignale und der bei Nicht-Anliegen des Hilfsfeldes $B_H$ erfaßten Signale zur eindeutigen Bestimmung von Drehwinkeln bis zu 360°.

10. Verfahren nach Anspruch 9, **dadurch gekennzeichnet, daß** die Sensoranordnung zwei insbesondere um 45° gegeneinander verdrehte Brückenschaltungen, insbesondere Wheatstone-Brücken, aufweist.

11. Verfahren nach Anspruch 10, **dadurch gekennzeichnet, daß** die Korrelierung mittels einer Bereichsfunktion F der Form

$$F = ((0°\leq\alpha_{AMR180}\leq f(\alpha_1,\alpha_2))UND((\delta U_{cos}>S)ODER((\delta U_{sin}<-S)UND(|\delta U_{cos}|<S)))) \ ODER$$

$$((f(\alpha_1,\alpha_2)<\alpha_{AMR180}\leq180°)UND((\delta U_{cos}>S)ODER((\delta U_{sin}>S)UND(|\delta U_{cos}|<S))))$$

durchgeführt wird, wobei $\alpha_{AMR180}$ ein ohne Anliegen des Hilfsfeldes $B_H$ erfaßter Drehwinkel, S eine einstellbare Signifikanzschwelle, $\delta U_{cos}$ bzw. $\delta U_{sin}$ die winkelabhängigen Änderungssignale der Sensoranordnung, und $f(\alpha_1, \alpha_2)$ eine Additions- bzw. Subtraktionsfunktion der Winkelausrichtungen der Brückenschaltungen bzw. des Hilfsfeldes in den Brückenschaltungen bezüglich einer Referenzrichtung darstellen.

12. Verfahren nach Anspruch 11, **dadurch gekennzeichnet, daß** $f(\alpha_1,\alpha_2)$ eine Funktion der Form $\alpha_1+\alpha_2$ ist.

13. Verfahren nach Anspruch 11, **dadurch gekennzeichnet, daß** $f(\alpha_1,\alpha_2)$ eine Funktion der Form $|\alpha_1-\alpha_2|$ ist.

**Claims**

1. Arrangement for detecting the angle of rotation of a rotatable element, in the case of which by evaluating properties of a sensor arrangement which can be influenced magnetically it is possible to detect in an evaluation circuit a first magnetic field $B_{ext}$ generated or influenced by a rotatable element, and to use the said field to determine the angle of rotation, the sensor arrangement supplying signals which can be assigned uniquely to a direction of the magnetic field $B_{ext}$ by using the magnetoresistive effect over a first angular range, in particular an angular range of 180°, **characterized by** means (2) for optionally applying an auxiliary magnetic field $B_H$ to the sensor arrangement, by means of which it is possible to achieve a modification of the signals which can be assigned to the direction of the first magnetic field $B_{ext}$ for the purpose of uniquely assigning an angle over a second angular range, in particular 360°.

2. Arrangement according to Claim 1, **characterized in that** the sensor arrangement has a number of magnetoresistive elements (1/1-1/4; 11/1-11/4) which are connected to at least two bridge circuits, in particular Wheatstone bridges (1, 11), of which one supplies a signal assigned to the cosine of the angle of the first magnetic field $B_{ext}$ with reference to a reference direction, and a further signal assigned to the sine of this angle.

3. Arrangement according to Claim 2, **characterized in that** the magnetoresistive elements are AMR strain gauges (1/1-1/4; 11/1-11/4).

4. Arrangement according to one of the preceding claims, **characterized in that** the directions of current flow in each of two magnetoresistive elements assigned to a bridge arm of the bridge circuits (1, 11) run perpendicular to one another.

5. Arrangement according to one of the preceding claims, **characterized in that** the bridge circuits (1, 11) are arranged rotated relative to one another, in particular by an angle of 45°.

6. Arrangement according to one of the preceding claims, **characterized in that** the auxiliary magnetic field $B_H$ has different directions in the bridge circuits (1, 11), these directions enclosing an angle of 45°, in particular.

7. Arrangement according to one of the preceding claims, **characterized in that** the magnetoresistive elements (1/1-1/4; 11/1-11/4) are of meandering design.

8. Arrangement according to one of the preceding claims, **characterized in that** the auxiliary magnetic field $B_H$ can be generated by means of a planar coil (2) which is arranged in a fashion electrically insulated with reference to the magnetoresistive elements (1/1-1/4; 11/1-11/4) and their metallization by means of a non-conducting intermediate layer.

9. Method for detecting the angle of rotation of a rotatable element, in the case of which by evaluating magnetic properties of a sensor arrangement a first magnetic field $B_{ext}$ caused or influenced by the rotatable element is detected in an evaluation circuit, and is used to determine the angle of rotation, **characterized by** the following steps:

a) determining the signals detected by the sensor arrangement upon application of the first field $B_{ext}$,
b) temporarily applying an additional auxiliary magnetic field $B_H$ to the sensor arrangement,
c) determining the change in the signals detected by the sensor arrangement with reference to the signals detected with the auxiliary field $B_H$ not applied, in order to obtain change signals dependent on the angle of rotation, and
d) correlating the change signals and the signals detected with the auxiliary field $B_H$ not applied, in order to uniquely determine angles of rotation up to 360°.

10. Method according to Claim 9, **characterized in that** the sensor arrangement has two bridge circuits, in particular rotated by 45° relative to one another, in particular Wheatstone bridges.

11. Method according to Claim 10, **characterized in that** the correlation is carried out by means of a range function F of form

$$F = ((0° \leq \alpha_{AMR180} \leq f(\alpha_1, \alpha_2)) \text{ AND } ((\delta U_{cos} > S) \text{ OR } ((\delta U_{sin} < -S)$$

$$\text{AND } (|\delta U_{cos}| < S)))) \text{ OR } ((f(\alpha_1, \alpha_2) < \alpha_{AMR180} \leq 180°) \text{ AND}$$

$$((\delta U_{cos} > S) \text{ OR } ((\delta U_{sin} > S) \text{ AND } (|\delta U_{cos}| < S)))),$$

$\alpha_{AMR180}$ representing an angle of rotation detected without application of the auxiliary field $B_H$, S representing a settable significant threshold, $\delta U_{cos}$ and $\delta U_{sin}$ representing the angle-dependent change signals of the sensor arrangement, and $f(\alpha_1, \alpha_2)$ representing an addition or subtraction function of the angular alignments of the bridge circuits or the auxiliary field in the bridge circuits with reference to a reference direction.

12. Method according to Claim 11, **characterized in that** $f(\alpha_1, \alpha_2)$ is a function of the form $\alpha_1 + \alpha_2$.

13. Method according to Claim 11, **characterized in that** $f(\alpha_1, \alpha_2)$ is a function of the form $|\alpha_1 - \alpha_2|$.

## Revendications

1. Dispositif de saisie de l'angle de rotation d'un élément rotatif, par lequel on exploite des caractéristiques magnéto-sensibles d'un dispositif de capteur, on détecte un premier champ magnétique $B_{ext}$ généré ou influencé par l'élément rotatif dans un circuit d'exploitation et on l'utilise pour déterminer l'angle de rotation,
le dispositif capteur utilisant l'effet magnéto-résistif dans une première plage angulaire en particulier une plage angulaire de 180°, pour fournir des signaux associés de manière bi-univoque à une direction du champ magnétique $B_{ext}$,
**caractérisé par**
des moyens (2) pour appliquer sélectivement au dispositif capteur un champ magnétique auxiliaire $B_H$ à l'aide duquel on modifie les signaux associés à la direction du premier champ magnétique $B_{ext}$ pour associer de manière bi-univoque un angle dans une seconde plage angulaire en particulier 360°.

2. Dispositif selon la revendication 1,
**caractérisé en ce que**
le dispositif capteur comporte un certain nombre d'éléments magnéto-résistifs (1/1-1/4 ; 11/1-11/4), branchés au moins en deux montages en pont, notamment des ponts de Wheatstone (1, 11), et dont l'un donne le cosinus de l'angle du premier champ magnétique $B_{ext}$ par rapport à une direction de référence et l'autre donne un signal correspondant au sinus de cet angle.

3. Dispositif selon la revendication 2,
**caractérisé en ce que**

les éléments magnéto-résistifs sont des bandes de mesure AMR (1/1-1/4 ; 11/1-11/4).

4. Dispositif selon l'une des revendications précédentes,
   **caractérisé en ce que**
   les directions de passage du flux sont perpendiculaires dans chaque fois deux éléments magnéto-résistifs associés à une branche des montages en pont (1, 11).

5. Dispositif selon l'une des revendications précédentes,
   **caractérisé en ce que**
   les montages en pont (1, 11) sont tournés en particulier l'un par rapport à l'autre d'un angle de 45°.

6. Dispositif selon l'une des revendications précédentes,
   **caractérisé en ce que**
   le champ auxiliaire magnétique $B_H$ correspond à des directions différentes dans les montages en pont (1, 11), ces directions faisant notamment un angle de 45°.

7. Dispositif selon l'une des revendications précédentes,
   **caractérisé en ce que**
   les éléments magnéto-résistifs (1/1-1/4; 11/1-11/4) sont en forme de méandre.

8. Dispositif selon l'une des revendications précédentes,
   **caractérisé en ce que**
   le champ auxiliaire magnétique $B_H$ est généré par une bobine planaire (2) qui est isolée électriquement par une couche intermédiaire non conductrice par rapport aux éléments magnéto-résistifs (1/1-1/4 ; 11/1-11/4) et leur métallisation.

9. Procédé de saisie de l'angle de rotation d'un élément rotatif selon lequel on exploite les caractéristiques magnétiques d'un dispositif capteur pour détecter dans un circuit d'exploitation un premier champ magnétique $B_{ext}$ généré ou influencé par l'élément rotatif et on l'utilise pour déterminer l'angle de rotation,
   **caractérisé par** les étapes suivantes :

   a) on détermine les signaux saisis par le dispositif capteur en appliquant le premier champ $B_{ext}$,
   b) on applique de temps en temps un champ magnétique auxiliaire $B_H$ supplémentaire au dispositif capteur,
   c) on détermine la variation des signaux saisis par le dispositif capteur par rapport aux signaux saisis lorsqu'on n'applique pas le champ magnétique auxiliaire $B_H$ pour obtenir des signaux de variation dépendant de l'angle de rotation, et
   d) on fait une corrélation des signaux de modification et des signaux saisis en l'absence de champ auxiliaire $B_H$ pour déterminer de manière bi-univoque les angles de rotation sur 360°.

10. Procédé selon la revendication 9,
    **caractérisé en ce que**
    le dispositif capteur comporte deux montages en pont tournés notamment de 45° l'un par rapport à l'autre et en particulier des ponts de Wheatstone.

11. Procédé selon la revendication 10,
    **caractérisé en ce qu'**
    on décrit la corrélation par une fonction de plage F de la forme suivante

$$F = ((0° \leq \alpha_{AMR180} \leq f(\alpha_1, \alpha_2)) \text{ ET } ((\delta U_{cos} > S) \text{ OU } ((\delta U_{sin} < -S) \text{ ET } (|\delta U_{cos}| < S)))) \text{ OU}$$

$$((f(\alpha_1, \alpha_2) < \alpha_{AMR180} \leq 180°) \text{ ET } ((\delta U_{cos} > S) \text{ OU } ((\delta U_{sin} > S) \text{ ET } (|\delta U_{cos}| < S)))),$$

dans laquelle $\alpha_{AMR180}$ est l'angle de rotation saisi sans appliquer le champ auxiliaire $B_H$, S est un seuil de signification réglable, $\delta U_{cos}$ et $\delta U_{sin}$ sont des signaux de variation du disposition capteur dépendant de l'angle et $f(\alpha_1, \alpha_2)$ représente une fonction d'addition ou de soustraction des directions angulaires des montages en pont ou du champ auxiliaire dans les montages en pont par rapport à une direction de référence.

**12.** Procédé selon la revendication 11,
**caractérisé en ce que**
f ($\alpha_1$, $\alpha_2$) est une fonction de la forme $\alpha_1 + \alpha_2$.

**13.** Procédé selon la revendication 11,
**caractérisé en ce que**
f ($\alpha_1$, $\alpha_2$) est une fonction de la forme valeur absolue, $|\alpha_1 - \alpha_2|$

FIG.1

FIG.2

FIG.3